Europäisches Patentamt

(19) European Patent Office

Office européen des brevets

(11) Publication number: **0 075 476**
A2

## (12) EUROPEAN PATENT APPLICATION

(21) Application number: **82304948.1**

(22) Date of filing: **21.09.82**

(51) Int. Cl.³: **H 01 L 31/06, H 01 L 27/14**

(30) Priority: **21.09.81 US 304132**

(43) Date of publication of application: **30.03.83**
**Bulletin 83/13**

(84) Designated Contracting States: **DE FR GB**

(71) Applicant: **Honeywell Information Systems Inc.,
200 Smith Street, Waltham Massachusetts 02154 (US)**

(72) Inventor: **Gurnee, Mark N., 718 Grove Street,
Framingham Massachusetts 01701 (US)**

(74) Representative: **Riddle, John et al, Honeywell Control
Systems Ltd. Patent Department Charles Square,
Bracknell, Berks. (GB)**

(54) **Photovoltaic detectors.**

(57) A photovoltaic detector includes a guard junction area (7) within a diffusion lenght of a radiation detecting area (6) both areas being formed on a photosensitive substrate (1). To reduce the effects of noise and so-called dark currents, bias means is provided to hold said guard junction area at a more reverse bias voltage than the radiation detecting area.

# PHOTOVOLTAIC DETECTORS

The present invention relates to photovoltaic detectors, and more particularly photovoltaic detectors having small detection areas, as used in infrared imaging systems.

Two of the factors which control performance of photovoltaic detectors are noise and so-called dark current at the detector operating bias voltage. Each factor is affected both by conditions intrinsic to the detector, and by conditions associated with the incident radiation flux. When the effects of incident radiation upon a detector dominate its performance, it is operating at its ultimate sensitivity called the "background limited infrared performance." To achieve this level of performance, it is necessary to reduce the intrinsic current and noise levels through selection of suitable operating bias voltage and detector design.

For many designs and operating conditions, a typical photovoltaic detector, not incorporating the present invention, operates in the diffusion limited region where both dark current and noise are due to the collection of thermally excited electrons and/or holes generated within a few minority carrier diffusion lengths of the junction. For example, diffusion current is usually the dominant component of the dark current for detectors sensitive to the infrared waveband of 8 to 12 micrometers (8 to 12 $\mu$m) in mercury cadmium telluride (HgCdTe) photodiodes at temperatures of roughly 77 degrees Kelvin (77K) and above, and in the infrared waveband (3-5 $\mu$m) in HgCdTe photodiodes at temperatures of roughly 170K and above.

The magnitude of diffusion current and its associated noise within a detector are determined by the electrical conditions in the detector within a few minority diffusion lengths of the junction. Minority carrier diffusion lengths as long as 100 $\mu$m in p-type Hg Cd Te detector materials have been measured. These lengths are greater than the small detector dimension required for some infrared imaging systems, which dimension is typically 25-50 $\mu$m. As a result

in diffusion limited photovoltaic detectors, noise and excess current may be collected from a region of the detector beyond that necessary for signal response since the detector volume is greater than necessary by virtue of its lateral extent and depth. Detector performance may be improved by mechanical or electrical reduction of noise and dark current collection. This may be accomplished by mechanical or electrical reduction of the volume of detector material to that actually required for signal collection.

In the past, reduction of detector thickness has been recognized as a means of reducing detector volume. One additional way of reducing detector volume has been to etch away excess detector material to form mesas with areas equal to the desired detector area, thereby physically removing the excess detector material as is done in thinning. However, this approach is difficult to control because of problems with physical definition and removal of the unwanted material. In addition, the newly exposed edges of detector material must be properly treated to prevent their becoming a source of excess current and noise.

It is accordingly an aim of the present invention to provide an improved photovoltaic detector which reduces the contribution of excess detector volume to detector signal, noise and dark current, and which is not restricted to any particular detector geometry or size, nor to physical removal of substrate material.

According to the present invention, there is provided a photovoltaic detector comprising a substrate including a photosensitive material; and radiation detecting material formed on said substrate; characterized in that a guard junction material is formed on said substrate and located within a diffusion length of said primary detecting material; and in that bias means is provided to hold said guard junction material at a more reverse bias voltage than said radiation detecting material, whereby said guard junction material intercepts excess noise and currents which would otherwise diffuse to said primary detecting junction material so as to improve the performance of said detector.

Embodiments of the invention will now be described, by way of example, with reference to the accompanying drawings, in which:

Figure 1 is an isometric view of one embodiment of photovoltaic detector in accordance with the present invention;

Figure 2 is a cross-sectional view of the detector of Figure 1;

Figures 3A and 3B are isometric views of the zones of detector and guard junctions of anternative embodiments of the present invention for a single detector and for a detector array, respectively;

Figures 4A, 4B and 4C show photoresist masks used to ion implant the element boron, thereby defining the detector and guard junction areas, etch contact cuts, and define indium contact strips for the detector and guard junctions, respectively; and

Figure 5 is a block diagram of a detector of the present invention together with other system components.

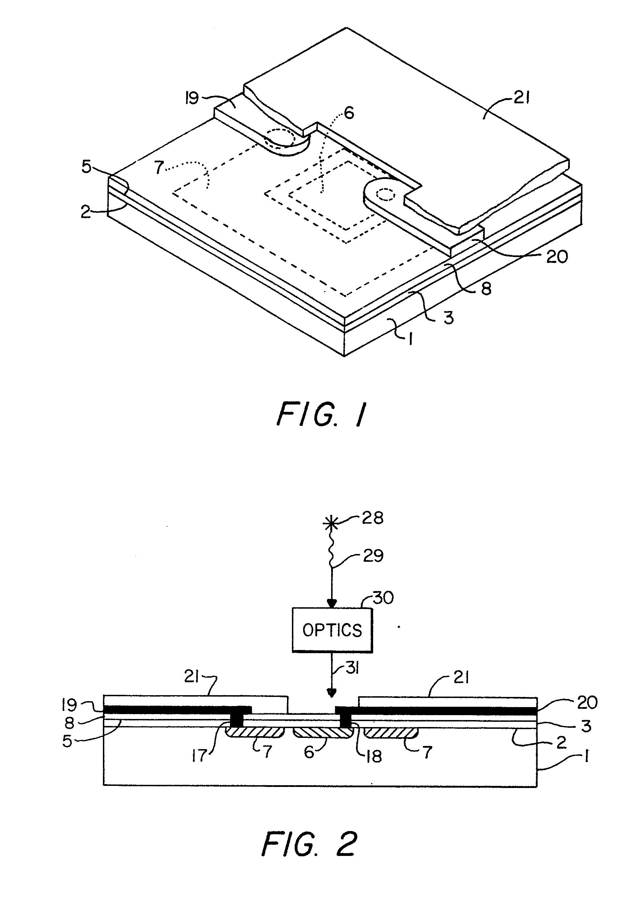

Referring to Figures 1, 2, 4A, 4B and 4C, the fabrication of the photovoltaic detector with a guard junction will now be described. A block of photosensitive semiconductor material 1, for example, p-carrier type $Hg_{0.7}Cd_{0.3}Te$ has its surface 2 passivated through techniques well-known in the art. For example, surface 2 is etched in a solution of bromine methanol. A thin (1000 angstroms) layer of insulating material 3, such as zinc (ZnS), is deposited on the etched surface through a process of sputtering or evaporation, also well-known in the art.

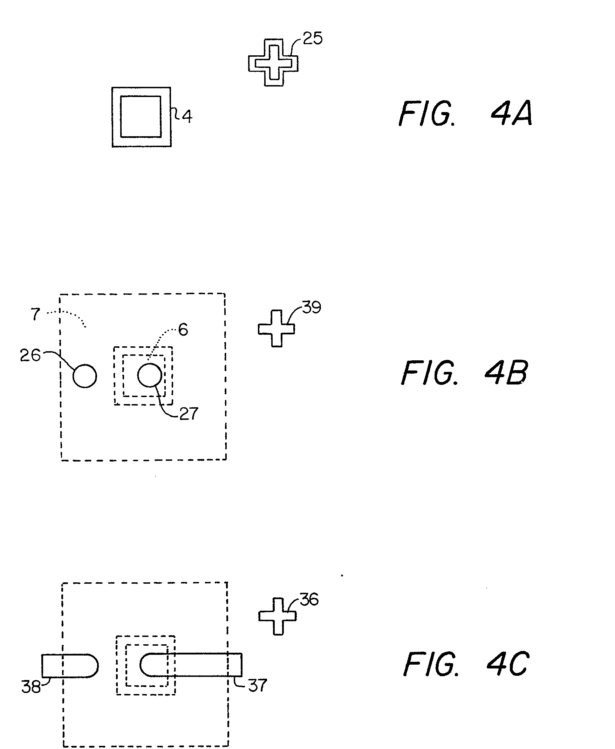

A photoresist mask 4, shown in Figure 4A, is applied to surface 5 of material 3 to delineate the areas which will become a detector area 6 and an associated guard junction area 7. A cross pattern 25 is provided for alignment of subsequent patterned layers. The detector area 6 and guard junction area 7 are formed by the ion implantation of appropriate dopants through the windows of the mask and through insulating layer 3 into substrate 1. As an example, boron might be used to form n-carrier type junctions in a p-type $Hg_{0.7}Cd_{0.3}Te$ substrate. Alternatively, junction areas 6 and 7 could be formed in substrate 1 by the known techniques of diffusion, or through formation of Schottky barriers.

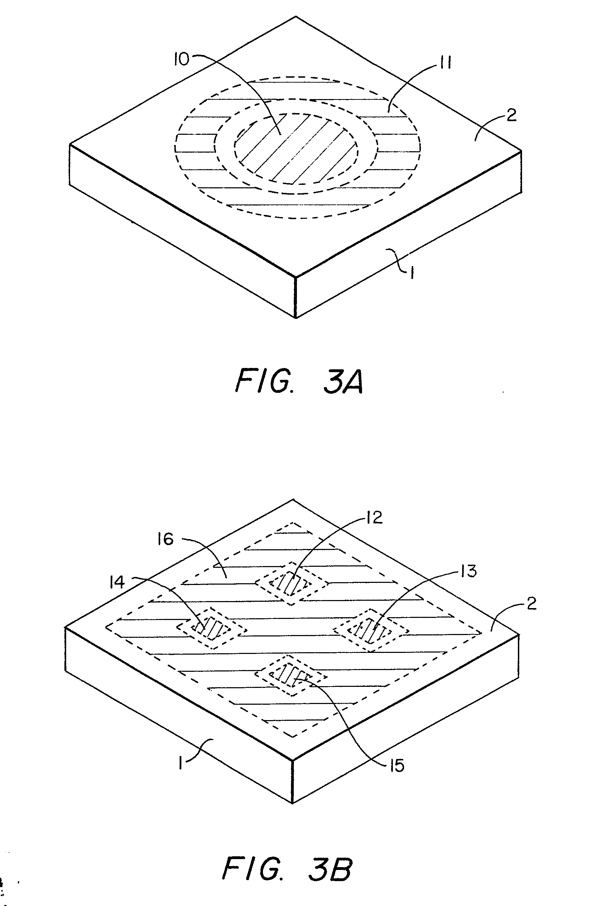

The width of mask 4 which separates areas 6 and 7 must be less than the minority carrier diffusion length of the substrate material, and may be constrained by the width of material (typically 4-8 μm) which can be delineated by standard photoresist techniques. As shown in Figures 3A and 3B, the geometry of detector guard junctions might be significantly different in other embodiments of the present invention. For example, a single detector area 10 might be circular with an annular guard junction 11, or in the case of a detector array, each individual element may be surrounded by individual guard junctions or as in Figure 3B each element 12, 13, 14 and 15 is surrounded by a common guard junction 16. However, all embodiments would include one or more guard junctions which lie within a minimum diffusion length of the detector area boundary.

A second film of insulating material 8, typically 4000 angstroms of ZnS may be deposited on surface 5 of layer 3 to provide additional protection against electrical shorting between the substrate 1 and subsequent metallizations 19 and 20.

Contact cuts 17 and 18 are made through layers 3 and 8 to substrate 1 by the well-known techniques of photoresist mask and chemical etch, plasma etch, or ion beam milling. Circular patterns 26 and 27 are the photoresist mask for chemical etch of contact cuts 17 and 18, respectively. Cross pattern 29 is positioned over cross pattern 25 to properly align the mask. Using a standard photoresist liftoff process, thin film metallizations, for example, 4000 angstroms of indium, are deposited on surface 2 of substrate 1 as exposed by cuts 17 and 18, and on surface 21 of insulating layer 8, to form electrical contact strips 19 and 20 for detector 6 and guard junction 7, respectively. Figure 4C shows the photoresist masks 37 and 38 used to define the electrical contact strips 19 and 20. Cross pattern 36 is positioned over the other cross patterns 25 or 39.

A mask 21 which is opaque in the desired spectral region may be applied above all exposed metallizations and insulating layers such that only the area directly above detector area 6 is exposed to incident radiation 29 collected by optics 30, thereby reducing unwanted photocurrent collection by the guard junction area 7. The mask 21 might include 1000 angstroms of gold defined and deposited by the photoresist liftoff process. Alternatively, the mask 21 might be applied before defining contact strips 19 and 20, or before application of the second insulating layer 8.

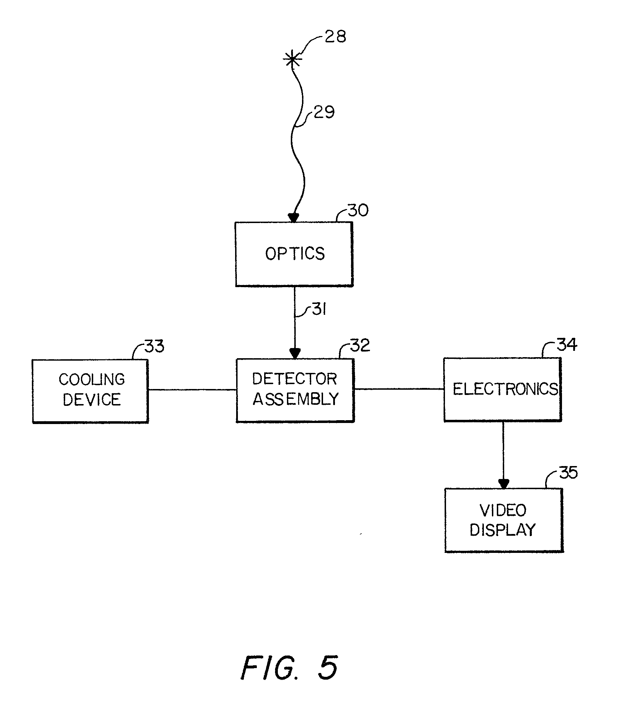

A typical infrared detection system incorporating the present detector is shown in Figure 5. Electromagnetic radiation 29 emitted or reflected from a scene of interest 28 enters collection optics 30, and is focused along optic axis 31 onto a photovoltaic detector assembly 32. This assembly 32 might include a single detector, as shown in Figures 1 and 3A, or a detector mosiac focal plane as shown in Figure 3B. Optics 30 might include a simple starring collection system, or a more complicated parallel or serial opto-mechanical scan mechanism.

Referring to Figure 1 and Figure 5, energy 29 collected by optics 30 is transmitted along optical axis 31 through the window of optical mask 21 and through insulating layers 3 and 8, where it impinges upon detector area 6 of substrate 1. Minority carriers generated within detector area 6 create an electrical signal representative of the electromagnetic flux of the scene of interest at the detector. This signal is carried by contact strip 20 to an electronics package 34, which converts these electronic signals to some integrated format, for example, to a video display 35 of the scene.

Detector assembly 32 is fixed at the proper temperature by use of cooling device 33.

The exact effect of the guard junction is difficult to calculate for practical detector geometries. However, calculations using simpler geometries indicate that, whether operating the detector at zero or reverse bias, the detector noise and dark current are substantially decreased in the presence of the guard junction held at a sufficiently reverse bias voltage. The guard junction must always be held at a reverse bias voltage greater than the detector area operating bias voltage to effect improved detector performance, i.e. (more positive for detectors which are formed of n-type regions on p-type detector material, and more negative for detectors which are formed of p-type regions on n-type detector material.

CLAIMS

1. A photovoltaic detector comprising a substrate including a photosensitive material; and radiation detecting material formed on said substrate; characterized in that a guard junction material (7) is formed on said substrate and located within a diffusion length of said primary detecting material (6); and in that bias means is provided to hold said guard junction material at a more reverse bias voltage than said radiation detecting material, whereby said guard junction material intercepts excess noise and currents which would otherwise diffuse to said primary detecting junction material so as to improve the performance of said detector apparatus.

2. The detector of Claim 1, characterized in that said guard junction material surrounds said radiation detecting material (Figure 3A).

3. The detector of Claim 1 or 2, characterized in that said radiation detecting and junction materials are formed on said substrate by ion implantation of dopant material, by a diffusion process or by the formation of Schottky barriers.

4. The detector of Claim 1, 2 or 3, characterized in that a plurality of areas of detecting material is provided each surrounded by individual areas of junction material or surrounded by a common area of junction material (Figure 3B).

5. The detector of any one of the proceding Claims, characterized in that said substrate may be made from any one of the following said detector materials: mercury cadmium telluride, indium antimonide, lead telluride, lead tin telluride, indium arsenide atimonide, and galium arsenide atnimonide.

FIG. 1

FIG. 2

0075476

FIG. 3A

FIG. 3B

0075476

FIG. 4A

FIG. 4B

FIG. 4C

FIG. 5